# EUROPÄISCHE PATENTSCHRIFT

(11) **EP 0 798 830 B1**
(45) Veröffentlichungstag und Bekanntmachung des Hinweises auf die Patenterteilung: **25.10.2000**
(21) Anmeldenummer: 96250172.2
(22) Anmeldetag: 09.08.1996
(51) Int. Cl.: H01S 3/098, H01S 5/10

(54) **Wellenlängenumschaltbarer gewinngeschalteter Fabry-Perot-Halbleiterlaser**
Wavelength switchable gain-switched Fabry-Perot semiconductor laser
Laser à semi-conducteur Fabry-Perot à commutation du gain à longueur d'onde commutable

(43) Veröffentlichungstag der Anmeldung: 01.10.1997
(73) Patentinhaber: Huhse, Dieter, 12167 Berlin (DE); Schell, Martin, Dr., 13353 Berlin (DE); Utz, Wolfgang, 10435 Berlin (DE); Bimberg, Dieter, Prof. Dr., 14089 Berlin (DE)
(72) Erfinder: Huhse, Dieter, 12167 Berlin (DE); Schell, Martin, Dr., 13353 Berlin (DE); Utz, Wolfgang, 10435 Berlin (DE); Bimberg, Dieter, Prof. Dr., 14089 Berlin (DE)

(56) Entgegenhaltungen:
- EP-A- 0 468 826
- WO-A-95/29424
- ELECTRONICS LETTERS, Bd. 31, Nr. 23, 9.November 1995, Seite 2008/2009 XP000546733 YU J ET AL: "FOURIER-TRANSFORM-LIMITED 2.5PS LIGHT PULSES WITH ELECTRICALLY TUNABLE WAVELENGTH (15 NM) BY HYBRIDLY MODELOCKING A SEMICONDUCTOR LASER IN A CHIRPED BRAGG GRATING FIBRE EXTERNAL CAVITY"
- IEEE PHOTONICS TECHNOLOGY LETTERS, Bd. 5, Nr. 1, 1.Januar 1993, Seiten 28-31, XP000335389 MORTON P A: "MODE-LOCKED HYBRID SOLITON PULSE SOURCE WITH EXTREMELY WIDE OPERATING FREQUENCY RANGE"

## Beschreibung

Die Erfindung betrifft einen wellenlängenumschaltbaren, gewinngeschalteten Fabry-Perot-Halbleiterlaser nach dem Oberbegriff des Patentanspruchs 1.

Eine derartige Anordnung ermöglicht den Bau einer einfachen, kompakten und robusten Quellen zur Erzeugung wellenlängenumschaltbarer Laserpulse.

Anordnungen zur Erzeugung wellenlängenumschaltbarer Laserpulse durch entspiegelte Fabry-Perot-Halbleiterlaser sind bekannt, z.B. aus der Doktorarbeit von Jin Yu. angefertigt am Fachbereich Physik der Technischen Universität Berlin, 1995, Seiten 49-55. Bei der bekannten Anordnung, die auf der Modenkopplung basiert, ist es jedoch nötig, die der externen Kavität zugewandte Facette der Halbleiterlaserdiode mit einer qualitativ hochwertigen Antireflexionsschicht zu versehen, so daß sich eine Restreflektivität von unter 0.1 % ergibt. Diese Antireflexionsschicht herzustellen ist technologisch nicht einfach und teuer.
Anordnungen zur Erzeugung wellenlängenumschaltbarer Laserpulse durch nicht entspiegelte Fabry-Perot-Halbleiterlaser sind bekannt, z.B. aus Veröffentlichungen von S. Lundqvist et al., Appl. Phys. Lett., vol. 43 (1983). Seiten 715-717, oder L.P. Barry et al., IEEE Photon. Technol. Lett., vol. 5 (1993), Seiten 1132-1134. Bei den bekannten Anordnungen wird zur Wellenlängenselektion in einer externen Kavität nur ein schmalbandiges Element (z.B. Reflexionsgitter oder Fabry-Perot-Filter) verwendet. Eine Änderung der Emissionswellenlänge des gewinngeschalteten Fabry-Perot-Halbleiterlasers ist nur über eine mechanische Änderung des wellenlängenselektiven Elements (z.B. Drehen des Gitters) möglich. Diese mechanische Änderung ist naturgemäß langsam und erlaubt somit maximale Umschaltraten die im 100 Hz Bereich liegen. Ebenfalls bekannt ist die Verwendung von sehr langen (>1 km) externen, dispersiven Kavitäten zum langsamen Abstimmen der Wellenlänge eines gewinngeschalteten Fabry-Perot-Halbleiterlasers durch Änderung der Frequenz der elektrischen Strompulse, wie es z.B. in der Veröffentlichung von D. Huhse et al., Electron. Lett., vol. 30 (1994), Seiten 157-158, beschrieben ist. Allerdings ist diese Anordnung aufgrund der verwendeten langen Kavität nicht zum schnellen Umschalten der Wellenlänge geeignet und solches wurde auch nie berichtet.

Weiterhin bekannt sind komplizierte, spezielle Mehrkontakt-Halbleiterlaserstrukturen, mit denen kurze, wellenlängendurchstimmbare Laserpulse generiert werden können, wie z.B. Tunable Twin Guide Laser, über die z.B. von M.C. Amann et al. in IEEE Photon. Technol. Lett., vol. 1 (1989), Seiten 253-254 berichtet wurde. Deren Herstellung ist jedoch äußerst kompliziert und teuer.

Der im Patentanspruch 1 angegebenen Erfindung liegt das Problem zugrunde, einen wellenlängenumschaltbaren, gewinngeschalteten Fabry-Perot-Halbleiterlaser mit einmodiger Laseremission zu schaffen, dessen Emissionswellenlänge schnell elektronisch umschaltbar ist.

Das Problem wird bei einer gattungsgemäßen Vorrichtung durch die kennzeichnenden Merkmale des Patentanspruchs 1 gelöst.
Weitere mögliche Ausgestaltungen der Erfindung sind den Unteransprüchen zu entnehmen.

Der Vorteil der Erfindung besteht darin, daß die Umschaltung der Emissionswellenlänge auf elektronischem Wege durch Änderung der Anregungsfrequenz der an den Halbleiterlaser angelegten kurzen elektrischen Strompulse ermöglicht wird, und daß die verwendete externe Kavität kurz ist. Dadurch wird nicht nur vollständig auf mechanisch zu bewegende Komponenten zur Änderung der Emissionswellenlänge verzichtet, sondern die Umlaufzeit der Laserpulse in der externen Kavität ist sehr klein. Somit ist das Potential für eine schnelle Abstimmung bzw. Umschaltung der Wellenlänge gegeben.

Eine mögliche Ausgestaltung der Erfindung ist im Patentanspruch 2 angegeben. Die Weiterbildung nach Patentanspruch ermöglicht die einfache Ausgestaltung einer externen Kavität, deren Fundamentalfrequenz für verschiedene Wellenlängen verschieden ist.

Eine weitere vorteilhafte Ausgestaltung der Erfindung ist im Patentanspruch 3 angegeben. Die Weiterbildung nach Patentanspruch 3 ermöglicht die einfache und stabile Ausgestaltung einer externen Kavität, deren Fundamentalfrequenz für verschiedene Wellenlängen verschieden ist. Durch den ausschließlichen Aufbau der externen Kavität mit Glasfasern wird der Gesamtaufbau extrem kompakt und stabil.

Eine weitere vorteilhafte Ausgestaltung der Erfindung ist im Patentanspruch 4 angegeben. Die Aufbau nach Patentanspruch 4 ermöglicht ebenfalls eine einfache, kompakte und extrem stabile Ausgestaltung einer externen Kavität, deren Fundamentalfrequenz für verschiedene Wellenlängen verschieden ist. Dabei wird die Kavität nur aus einem einzigen Fasergitter gebildet, was einen zusätzlichen Vorteil bieten kann.

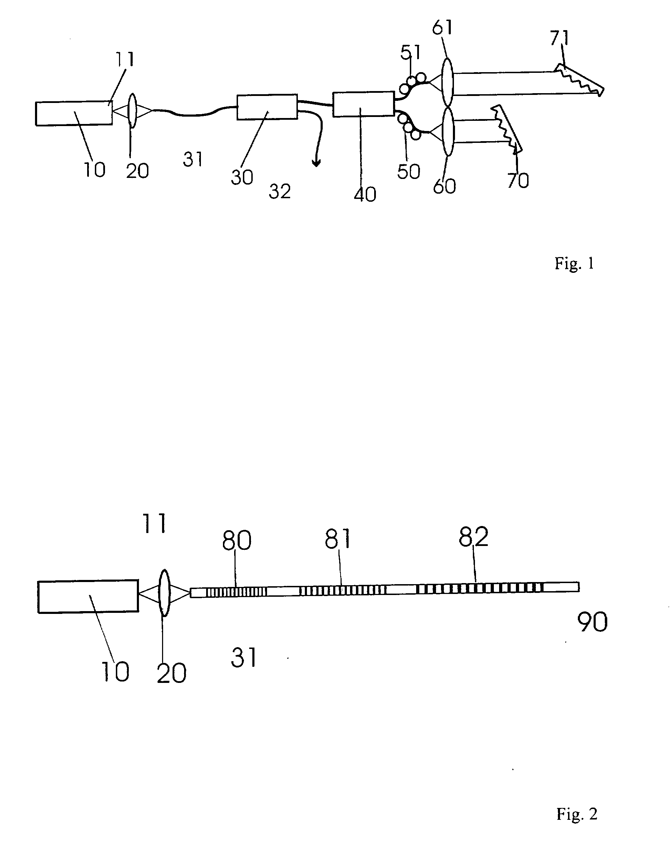

Die Erfindung wird im folgenden anhand von Ausführungsbeispielen, die in den Figuren 1 und 2 gezeigt sind, näher beschrieben.

Fig. 1 zeigt ein mögliches Ausführungsbeispiel der Erfindung nach Patentanspruch 2. Der Fabry-Perot-Halbleiterlaser (10) wird in Gewinnschaltung betrieben, wobei die Stärke der elektrischen Pulse so eingestellt wird. daß der Halbleiterlaser nur die erste Relaxationsoszillation zeigt. Die der externen Kavität zugewandte Facette (11) des Halbleiterlasers kann unbehandelt bleiben, d.h. sie braucht nicht z.B. antireflexbeschichtet zu werden, was gegenüber z.B. der Modenkopplung einen Vorteil darstellt. Über eine Einkoppeloptik, z.B. ein Mikroskopobjektiv (20), wird das vom Halbleiterlaser emittierte Licht in die Monomode-Glasfaser (31) eines faseroptischen Teilers (30) eingekoppelt. Die genaue Ausgestaltung der Einkoppeloptik ist nicht relevant. Ein Teil der vom Halbleiterlaser emittierten Laserstrahlung steht als eigentlich nutzbare Laserstrahlung am Ende der einen Glasfaser (32) des Teilers (30) zur Verfügung. Der andere Teil der Laserstrahlung wird in einem zweiten faseroptischen Teiler (40), der mit dem Ausgang des ersten faseroptischen Teilers (30) verbunden ist, in z.B. zwei gleich große Anteile aufgeteilt. Über je eine Linse (60, 61) wird das aus der Glasfaser ausgekoppelte Licht auf je ein Reflexionsgitter (70, 71) abgebildet, und von dort wellenlängenselektiv in die Glasfasern des faseroptischen Teilers (40) zurückgekoppelt. Von dort wird das Licht über den faseroptischen Teiler (30) und die Optik (20) zurück in den Fabry-Perot-Halbleiterlaser (10) gekoppelt. Über die beiden Polarisationssteller (50, 51) kann die Effizienz der Rückkopplung optimiert werden. Durch Umschalten der Frequenz der elektrischen Pulse der Gewinnschaltung zwischen den beiden verschiedenen Fundamentalfrequenzen (oder Harmonischen davon) der beiden durch die Gitter gebildeten externen Kavitäten kann die Wellenlänge der vom Halbleiterlaser emittierten Laserstrahlung zwischen den beiden durch die Gitter verschieden einstellbaren Wellenlängen hin- und hergeschaltet werden. Da der Umschaltvorgang innerhalb von weniger als 10 Umläufen des Lichtes in der Kavität abgeschlossen ist, lassen sich bei genügend kurzen externen Kavitätslängen extrem kurze Umschaltzeiten erzielen. Zum Beispiel hat eine ca. 10 cm langen Kavität eine Fundamentalfrequenz von ungefähr 1 GHz, wodurch sich Umschaltzeiten von unter 10 ns ergeben würden.

Fig. 2 zeigt ein mögliches Ausführungsbeispiel der Erfindung nach Patentanspruch 3. Das Ausführungsbeispiel unterscheidet sich von dem nach Fig. 1 dadurch, daß die externe Kavität vollständig aus einer Glasfaser mit mehreren verschiedenen (in diesem Beispiel drei) direkt räumlich hintereinander in die Glasfaser eingeschriebenen Fasergittern (80,81,82) besteht. Die Fasergitter sollten dabei Reflektivitäten von deutlich unter 100 % aufweisen. Die Laserstrahlung steht am Ende der Glasfaser (90) zur Verfügung.

Die Erfindung ist nicht auf die beschriebenen Ausführungsbeispiele beschränkt, sondern sinngemäß auf weitere anwendbar. So ist es z.B. möglich, anstelle der faseroptischen 1x2-Teiler (Fig. 1, 30 und 40) auch 2x2-Teiler zu verwenden, so daß zusätzliche Kontrollausgänge zur Verfügung stehen. Ebenso könnten anstelle der faseroptischen Teiler auch andere optische Leistungsteiler verwendet werden.

## Patentansprüche

1. Wellenlängenumschaltbarer, gewinngeschalteter Fabry-Perot-Halbleiterlaser mit einmodiger Laseremission durch Selbstinjektion in einer externen Kavität, dadurch gekennzeichnet, daß
a) die vom Halbleiterlaser emittierte Laserstrahlung in mehrere externe Kavitäten, die einen gemeinsamen Teil haben, mit einer Länge von weniger als 50 m eingekoppelt ist,
b) die Fundamentalfrequenzen der externen Kavitäten verschieden sind,
c) die den externen Kavitäten zugewandte Facette des Fabry-Perot-Halbleiterlasers eine Reflektivität von mehr als 3 % aufweist.
d) die Frequenz der an den Halbleiterlaser angelegten kurzen elektrischen Strompulse zwischen den verschiedenen Fundamentalfrequenzen oder den zugehörigen höheren Harmonischen der externen Kavitäten umgeschaltet wird und damit die Wellenlänge der emittierten Laserstrahlung zwischen den entsprechenden Wellenlängen umgeschaltet wird.

2. Wellenlängenumschaltbarer, gewinngeschalteter Fabry-Perot-Halbleiterlaser mit einmodiger Laseremission durch Selbstinjektion nach Anspruch 1, dadurch gekennzeichnet, daß die externen Kavitäten aus zwei oder mehr diskreten, wellenlängenselektiven Reflektoren aufgebaut sind.

3. Wellenlängenumschaltbarer, gewinngeschalteter Fabry-Perot-Halbleiterlaser mit einmodiger Laseremission durch Selbstinjektion nach Anspruch 1 oder Anspruch 2, dadurch gekennzeichnet, daß die externen Kavitäten aus zwei oder mehr räumlich hintereinander in einer Monomode-Glasfaser eingeschriebenen Reflexionsgittern mit verschiedenen Zentralwellenlängen und mit Reflektivitäten unter 80% bestehen.

4. Wellenlängenumschaltbarer, gewinngeschalteter Fabry-Perot-Halbleiterlaser mit einmodiger Laseremission durch Selbstinjektion nach Anspruch 1, dadurch gekennzeichnet, daß die externen Kavitäten aus einem breitbandigen, gechirpten, in einer Monomode-Glasfaser eingebrachten Reflexionsgitter mit einer Reflektivität von unter 80% bestehen, und die Bandbreite des Reflexionsgitters größer oder gleich dem Abstand zweier Fabry-Perot-Moden des gewinngeschalteten Fabry-Perot-Halbleiterlasers ist.

## Claims

1. Wavelength switchable gain-switched Fabry-Perot semiconductor laser with single mode laser emission by self injection in an external cavity, characterised in that
a) the laser radiation emitted from a semiconductor laser is coupled into a number of external cavities having a length of less than 50 m, which have a common part,
b) the fundamental frequencies the of external cavities arc different from each other,
c) the facet of the Fabry-Perot semiconductor laser which is facing the external cavities has a reflectivity of more than 3 %,
d) the frequency of the short electrical current pulses applied to the semiconductor laser is switched between the different fundamental frequencies or their respective higher harmonics of the external cavities and therefore the wavelength of the emitted laser radiation is switched between the respective wavelengths.

2. Wavelength switchable gain-switched Fabry-Perot semiconductor laser with single mode laser emission by self injection as claimed in Claim 1, characterised in that the external cavities are set up with two or more discrete wavelength selective elements.

3. Wavelength switchable gain-switched Fabry-Perot semiconductor laser with single mode laser emission by self injection as claimed in Claim 1 or Claim 2, characterised in that the external cavities consist of two or more reflection gratings, written spatial separated one behind the other into a single mode optical fibre, with different centre wavelengths and with reflectivities below 80 %.

4. Wavelength switchable gain-switched Fabry-Perot semiconductor laser with single mode laser emission by self injection as claimed in Claim 1, characterised in that the external cavities consist of a broad band, chirped reflection grating, introduced into a single mode optical fibre with a reflectivity below 80 %, and that the band width of the reflection grating is larger as or equal to the difference between two Fabry-Perot modes of the gain-switched semiconductor laser.

## Revendications

1. Laser à semiconducteur Fabry-Pérot à mode unique à commutation du gain à longueur d'onde commutable, characterisé en ce que
a) l'émission du laser à semiconducteur dans des cavités différentes qui ont une partie en commun est injectée avec une longueur moins de 50 m,
b) les fréquences fondamentales des cavités externes sont différentes,
c) la facette du laser à semiconducteur Fabry-Pérot en face de la cavité externe a une réflectivité de plus de 3 %,
d) la fréquence des pulses de courant électrique courtes appliquées au laser à semiconducteur peut être commutée entre les fréquences fondamentales différentes ou entre leurs harmoniques respectives des cavités externes et que pour cela la longueur d'onde de la radiation laser émise est commutées entre les longueurs d'onde respectives.

2. Laser à semiconducteur Fabry-Pérot à mode unique à commutation du gain à longueur d'onde commutable selon 1, characterisé en ce que les cavités externes sont montées avec deux ou plusieurs réflecteurs qui sont sélectives en longueur d'onde.

3. Laser à semiconducteur Fabry-Pérot à mode unique à commutation du gain à longueur d'onde commutable selon 1, ou 2, characterisé en ce que les cavités externes consistent en deux ou plusieurs réseaux de réflexion séparés dans l'espace et gravés l'un derrière l'autre dans un fibre optique à mode unique, chaque un avec une autre longeur d'onde centrale et une réflectivité de moins de 80 %.

4. Laser à semiconducteur Fabry-Pérot à mode unique à commutation du gain à longueur d'onde commutable selon 1. characterisé en ce que les cavités externes consistent d'un réseau de réflexion ( « chirped grating » ) de bande large, introduit dans un fibre optique à mode unique avec une réflectivité de moins de 80 %, et que la largeur de la bande du réseau de reflexion est supérieure ou égale à la différence entre deux modes Fabry-Pérot du laser à semiconducteur à commutation du gain.
